# EUROPEAN PATENT APPLICATION

(11) **EP 4 318 543 A1**
(43) Date of publication of application: **07.02.2024**
(21) Application number: 22188394.5
(22) Date of filing: 02.08.2022
(51) Int. Cl.: H01J 37/20

(54) **SAMPLE HOLDER FOR HOLDING A SAMPLE CARRIER, HANDLING TOOL AND CORRESPONDING METHODS**

(71) Applicant: Leica Mikrosysteme GmbH, 1170 Wien (AT); Universität Hamburg, 20148 Hamburg (DE)
(72) Inventor: Laugks, Tim, 22869 Schenefeld (DE); Thünauer, Roland, 21635 Jork (DE)
(74) Representative: DehnsGermany Partnerschaft von Patentanwälten

(57) **Abstract**

The invention relates to a sample holder (100) for holding a sample carrier (150), wherein the sample holder comprises a reception area configured to receive the sample carrier (150), wherein the sample holder comprises two legs, wherein the two legs are connected to each other and wherein each leg has a free end, and wherein the sample holder is configured to exert a clamping force (Fa, Fb, Fc, Fd) via the two legs to the sample carrier, in order to clamp the sample carrier (15) between the two legs, when the sample carrier is received in the reception area. The invention relates to a handling tool and to corresponding methods.

## Description

### Technical Field

The present invention essentially relates to a sample holder for holding a sample carrier, to a handling tool for handling such sample holder, and to corresponding methods.

### Background

In cryo-microscopy or cryo-electron microscopy, samples can be placed on sample carriers, typically having a grid for receiving the sample. The sample carrier with the sample can then be shock frozen in order to use the sample for inspection with the microscope. Handling of such typically small sample carriers can be difficult.

### Summary

In view of the situation described above, there is a need for improvement in handling sample carriers. According to embodiments of the invention, a holder for holding a sample carrier, a handling tool for handling such sample holder, and methods for handling such sample holder with the features of the independent claims are proposed. Advantageous further developments form the subject matter of the dependent claims and of the subsequent description.

An embodiment of the invention relates to sample holder for holding a sample carrier; such sample carrier can, for example, be a so-called autogrid, which will be described in more detail later. The sample holder comprises a reception area configured to receive the sample carrier; this reception area can be formed at least partly as a recess in a top surface of the sample carrier. Further, the sample holder comprises two legs, wherein the two legs are connected to each other (e.g., on one respective end) and wherein each leg has a free end. Further, the sample holder is configured to exert a clamping force via the two legs - and preferably also by the legs- to the sample carrier, in order to clamp the sample carrier between the two legs, when the sample carrier is received in the reception area. This allows easy fixation of the sample carrier in the sample holder without any external force after having placed the sample carrier in the sample holder; in particular, such fixation is provided by means of pre-tension, which can be provided by the special shape or geometry of the sample holder. In addition, such sample holder inherently can provide a specific shape for better orientation when handling the sample carrier (in the sample holder), what is of particular relevance for round shaped sample carriers. The sample holder can have, for example, a square shape (in cross section, e.g., parallel to the top surface).

In an embodiment of the invention, a first minimum distance between the free ends of the two legs, when the sample carrier is not received in the reception area and when no external force is exerted to the sample holder, is less than a second minimum distance between the free ends of the two legs, when the sample carrier is received in the reception area. In this way, the sample holder can provide a tension effect like a spring in order to effectively clamp the sample carrier.

According to a further embodiment of the invention, the sample holder is configured to exert the clamping force to the sample carrier such that the clamping force is equally distributed to the two legs. In other words, both legs exert an equal amount of force to the sample carrier, wherein these forces are typically orientated towards each other. This helps to efficiently fix the sample carrier without a risk to deform it.

According to a further embodiment of the invention, the sample carrier comprises several distinct clamping surfaces arranged to contact the sample carrier or an outer rim of the sample carrier, when the sample carrier is received in the reception area. Each of the two legs comprises at least part of each of at least two of the multiple clamping surfaces. The sample holder is configured to exert the clamping force via the several distinct clamping surfaces. This allows an even better and more uniform distribution of the force acting on the sample carrier. Any risk of deformation of the sample carrier is further reduced.

According to a further embodiment of the invention, the one or more clamping surfaces are arranged such that they form part of a barrel or a cone surface, when the sample carrier is received in the reception area. This allows particular efficient fixation of round shaped sample carriers like the mentioned so-called autogrids.

According to a further embodiment of the invention, the sample holder further comprises several distinct support surfaces configured to support the sample carrier (in particular, in a direction perpendicular to the top surface), when the sample carrier is received in the reception area. At least part of each of at least two of the multiple support surfaces is arranged at each one of the two legs and adjacent to a respective one of the multiple clamping surfaces. This allows improving fixation of the sample carrier in the sample holder, and, in particular, allows defining a specific position that the sample carrier has to have when received in the sample holder (this is particular with respect to a height, perpendicular to the top surface).

According to a further embodiment of the invention, the reception area is formed at least partly as a recess in a top surface of the sample holder. Further, the sample holder is U-shaped, seen in a plane parallel to the top surface, and at least a part of each of the two legs forms at least a part of the reception area. Such sample holder is very compact and easy to manufacture.

According to a further embodiment of the invention, the sample holder comprises a clearance area, wherein the clearance area is formed at least partly as a recess in a bottom surface of the sample holder. The bottom surface is opposite (and preferably also parallel to) the top surface. This clearance area is configured to, when the sample carrier is received in the reception area and clamped between the two legs, receive at least a part of another sample carrier of the same type (and, preferably, also of the same size and/or shape) without clamping the other sample carrier, when the other sample carrier is received in the reception area and clamped between the two legs of another sample holder of the same type. Such other sample carrier, thus, can dive into the bottom surface. This allows easy stacking of several sample holders, one above the other, with sample carriers clamped into the sample holders, while the clamped sample holders protruding from the respective top surfaces.

According to a further embodiment of the invention, the sample holder is configured for use in cryo-microscopy, i.e., the sample holder (or its material, from which it is made) has to be appropriate for low (cryo) temperatures of, e.g., less than 77 K. Specific materials particularly suitable for such sample holder are copper beryllium alloy, or copper alloy, or aluminium alloy, from which the sample can be made.

According to a further embodiment of the invention, the sample holder is made from a single piece. For example, the sample holder can be obtained by machining it from a solid piece of material or by means of 3D printing. This improves stability of the sample holder and reduces overall dimensions. Also, the tension effect mentioned above can effectively be obtained in this way.

According to a further embodiment of the invention, the sample holder comprises one or more channels, wherein the one channel or each of the more channels connects a surface of a side of the sample holder (e.g., the top surface) with a surface of a different side of the sample holder (e.g., the bottom surface). Such channels can improve cooling of the sample holder in that cooling fluid (e.g., during shock freezing as mentioned above, or for high pressure freezing) can flow through such channels.

According to a further embodiment of the invention, the sample holder comprises two or more operating recesses (or handling recesses), wherein the two or more operating recesses are located on the same first side (e.g., the top surface) of the sample holder. Such operating recesses can be used for handling the sample holder by means of a handling tool, which will be described in more detail later.

According to a further embodiment of the invention, at least one of the operating recesses is formed by the one or at least one of the more channels. This allows a dual use of the channels.

According to a further embodiment of the invention, the sample holder comprises two or more pins, wherein the two or more pins are located on the same second side of the sample holder, wherein the second side opposes the first side, and wherein the two or more pins are arranged such that they match with the two or more operating recesses of another sample holder. This allows easy stacking of multiple sample holders.

According to a further embodiment of the invention, a distance between the top surface and at least one of the several distinct support surfaces (as mentioned above), seen in a direction orthogonal to the top surface, is less than 0.4 mm or less than 0.35 mm. This results in typical sample carriers like autogrids, which have a thickness of 0.4 mm, protruding from the top surface, when received in the sample holder. This allows bringing microscopes, in particular, light microscopes to a very small distance from the sample provided on the sample carrier.

Another embodiment of the invention relates to an arrangement comprising the sample holder in one of the embodiments mentioned above having the support surfaces, and a sample carrier. The sample holder is configured such that, when the sample carrier is received in the reception area, clamped between the two legs and supported by the several distinct the support surfaces, the sample carrier protrudes from the top surface. This allows bringing microscopes, in particular, light microscopes to a very small distance from the sample provided on the sample carrier.

Another embodiment of the invention relates to a handling tool (or operating tool) for use with the sample holder in one of the embodiments mentioned above having the operating recesses. The handling tool comprises two ends fitting into the two or at least two of the more operating recesses of the sample holder. The handling tool is configured such that in absence of an external force to the operating tool the two ends are spaced apart from each other by a distance less than a distance of the two respective operating recesses, and the handling tool is configured as inverse tweezers such that a squeezing force applied to handling areas of the handling tool pushes the two ends apart. Such handling tool allows easy handling the sample holder (as the sample carrier is received in the sample holder, the sample holder has to be handled rather than the sample carrier as such). Due to the inverse tweezers mechanism, the sample carrier will stay clamped (fixed) in the sample holder, when the operating tool is inserted in the operating recess, but with no extern force applied.

According to a further embodiment of the invention, each of the two ends is configured as a gripping pin configured to fit into a respective one of the operating recesses. This allows easy manufacturing of the operating tool. According to an alternative embodiment of the invention, each of the two ends comprises two gripping pins, each gripping pin configured to fit into a respective one of the operating recesses. This allows handling sample holders having four operating recesses with better grip.

Another embodiment of the invention relates to a method of placing a sample carrier into a sample holder, using a handling tool. The method comprises the steps of: applying a squeezing force to handling areas of the operating tool; placing two ends of the handling tool into respective operating recesses of the sample holder, when the squeezing force is applied; placing the sample carrier in a reception area of the sample holder, while the squeezing force still or again is applied; removing the squeezing force from the handling tool; and removing the two ends of the handling tool from the respective operating recesses of the sample holder. In an embodiment, the sample carrier is placed into a sample holder of one of the embodiments mentioned above. In another embodiment, the handling tool of one of the embodiments mentioned above is used.

Another embodiment of the invention relates to a method of removing a sample carrier from a sample holder, using a handling tool. The method comprises the steps of: applying a squeezing force to handling areas of the operating tool; placing two ends of the handling tool into the respective operating recesses of the sample holder, while the squeezing force is being applied; removing the sample carrier from a reception area of the sample holder, while the squeezing force still or again is applied; removing the squeezing force from the operating tool; and removing the two ends of the handling tool from the respective operating recesses of the sample holder. These are easy and effect ways of handling sample carriers in connection with sample holders. In an embodiment, the sample carrier is removed from a sample holder of one of the embodiments mentioned above. In another embodiment, the handling tool of one of the embodiments mentioned above is used.

Further advantages and embodiments of the invention will become apparent from the description and the appended figures.

It should be noted that the previously mentioned features and the features to be further described in the following are usable not only in the respectively indicated combination, but also in further combinations or taken alone, without departing from the scope of the present invention.

### Short description of the Figures

- Fig. 1a: schematically shows a sample holder according to an embodiment of the invention in a perspective view;
- Fig. 1b: schematically shows a sample carrier for use with a sample holder in a perspective view;
- Fig. 1c: schematically shows an arrangement of the sample holder of Fig. 1a and the sample carrier of Fig. 1b;
- Fig. 2: schematically shows the arrangement of Fig. 1c in a side view;
- Fig. 3: schematically shows multiple ones of the arrangements of Fig. 2 stacked and in cross section;
- Fig. 4a: schematically shows a handling tool according to an embodiment of the invention;
- Fig. 4b: schematically shows an enlarged view of part of the handling tool of Fig. 4a;
- Fig. 5a: schematically shows a handling tool according to a further embodiment of the invention;
- Fig. 5b: schematically shows an enlarged view of part of the handling tool of Fig. 5a;
- Fig. 6: schematically shows a method according to an embodiment of the invention in a flow diagram;
- Fig. 7: schematically shows a method according to a further embodiment of the invention in a flow diagram.

### Detailed Description

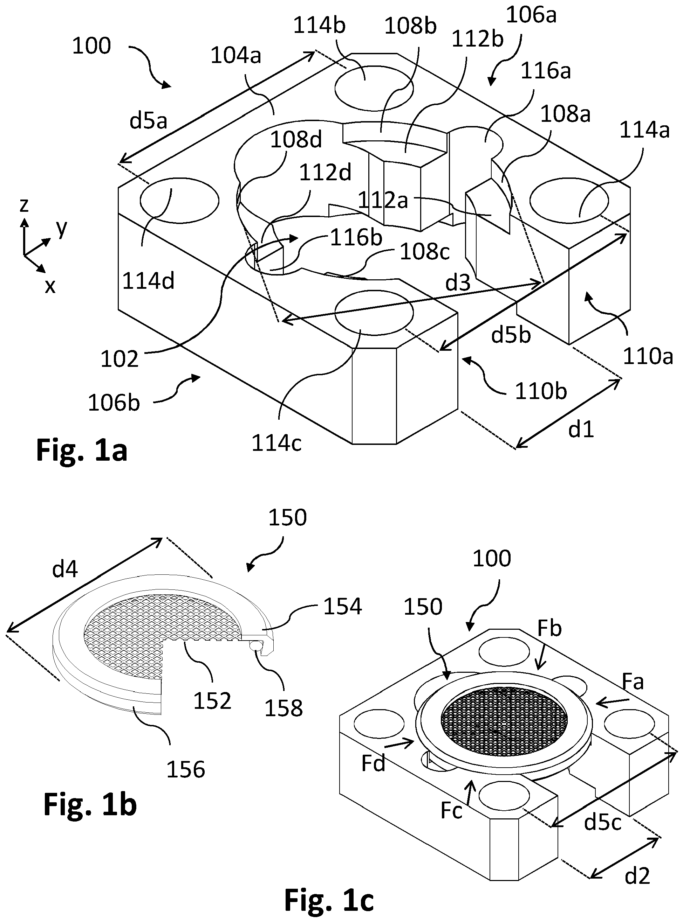

Fig. 1a schematically illustrates a sample holder 100 according to an embodiment of the invention in a perspective view. The sample holder 100 is configured for receiving and holding a sample carrier. Fig. 1b schematically illustrates such sample carrier 150 in a perspective view. Fig. 1c schematically illustrates an arrangement comprising the sample holder 100 of Fig. 1a and the sample carrier of Fig. 1b. In the following, Figs. 1a, 1b and 1c shall be described in combination. For ease of reference, a Cartesian coordinate system with axes x, y and z is shown in Fig. 1a, which also applies to Figs. 1b and 1c.

The sample carrier 150 shall briefly be described in the following, with respect to Fig. 1b, which shows the sample carrier 150 with a section cut out. The sample carrier 150 shown in Fig. 1b is also called an autogrid and is typically used in cryo-electron microscopy.

For cryo-electron microscopy, biological samples are shock-frozen (vitrified) on grids in order to be able to examine them again with cryo-electron microscopes. Such grids like grid 152 shown in Fig. 1b comprise, for example, a metal grid (e.g. made of copper or gold) on which a very thin carrier network (e.g. made of carbon) can be applied.

Due to their flat shape, these grids are suitable for being quickly shock-frozen by rapid immersion in a cryo liquid like liquid nitrogen-cooled propane-ethane mixture so that amorphous ice forms (vitrification). After that, relevant areas for cryo-transmission electron microscopy (cryo-TEM), for example, can be localized and thinned out. For this purpose, the grids are typically transferred between different devices under cryo conditions (77 K), a so-called cryo-workflow. High-end transmission electron microscopes, for example, can have an automatic loading mechanism (autoloader) for which the grids are typically clamped in round frames (e.g., metal frames), like frame 154 in Fig. 1b. The combination of sample grid 152 and (metal) frame is a sample carrier called autogrid, as shown in Fig. 1b. In addition, a ring 158 can be used in order to fix the grid 152 to or in the frame 154.

It is almost impossible to use a fragile grid (also called baregrid) like grid 152 through the entire cryo workflow undamaged and then to clamp it in a metal frame like frame 154 for the TEM or another application at the end. Since autogrids like sample carrier 150 enable safer pick-up with tweezers and thus reproducible sample transfer, they have become a standard for the entire cryo-workflow in cryo-electron microscopy. In a modern cryo-workflow, the grids are now clamped into the metal frames immediately after vitrification.

Such sample carriers like autogrids typically have to be attached to different holders in the correct orientation for each individual device or microscope. Due to the round geometry, which is specified by the autoloader, precise orientation under cryogenic conditions has turned out to be very difficult. Repeated picking up with tweezers and long transfer times inevitably lead to more contamination on the samples and also make reproducibility and high sample throughput more difficult. For new and inexperienced users, this can even lead to a complete loss of samples.

The inventors have recognized that such problems can be overcome by the sample holder, which will be described in the following. Due to the preferably cuboidal or square shape (square in cross section), such sample holder can also be called a "Squaregrid" holder.

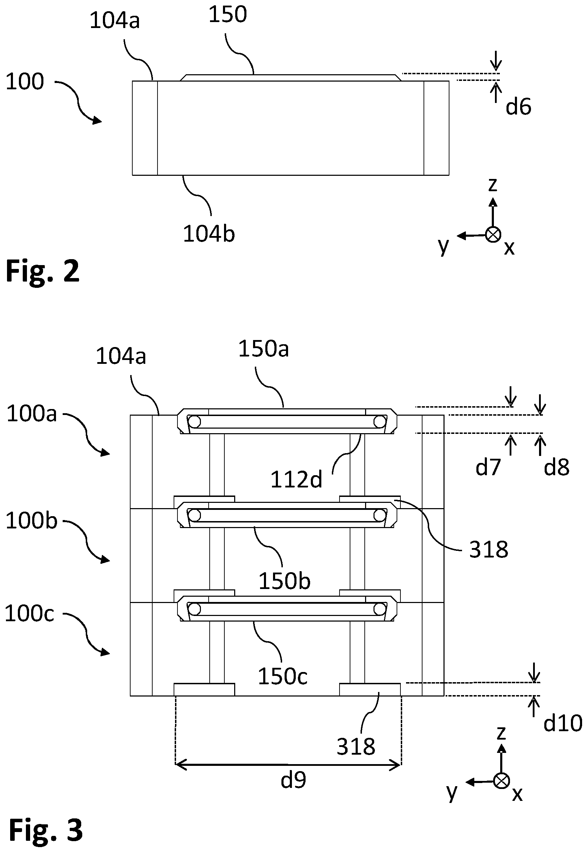

The sample holder 100 comprises a reception area 102 configured to receive the sample carrier 150; while in Fig. 1a the reception area 102 is shown without the sample carrier 150, in Fig. 1c the sample carrier 150 is received therein. The sample holder 100 can have a top surface (or top side) 104a (here: parallel to the x-y-plane) and a bottom surface (or bottom side) 104b (see later Fig. 2), wherein the bottom surface 104b is opposite to the top surface 104a (and, thus, also parallel to the x-y-plane). The top side 104a is the side of the sample holder 100 that is intended to receive the sample carrier 150, i.e., in an embodiment, the reception area 102 is formed at least partly as a recess in the top surface 104a. The sample holder 100 can basically have the shape of a cuboid or block; thus, further circumferential sides can be identified at the sample holder 100.

In the embodiment shown in Figs. 1a and 1c, the sample holder 100 is made of a single piece; a preferably used material from which the sample carrier is made of, is copper. Also, beryllium alloy or copper alloy or aluminium alloy can be used. These materials are particularly suitable for low or cryogenic temperatures.

Further, the sample holder 100 comprises two legs 106a and 106b, wherein the two legs 106a, 106b are connected to each other and wherein each leg has a free end 110a and 110b, respectively. In the embodiment shown, the two legs 106a, 106b are integrally connected to each other as they are made from the same piece or block of material, due to the single piece of material from which the entire sample holder 100 is made of. In an embodiment, the sample holder 100 is U-shaped, seen in a plane parallel to the top surface 104, and at least a part of each of the two legs 106a, 106b forms at least a part of the reception area 102.

It is noted that, in general, also two or more components can be used to form the sample holder; for example, the two legs can be made of separate material blocks which are connected to each other, for example, by means of soldering or welding or by means of a screw of other fixing means.

Further, the sample holder 100 is configured to exert a clamping force via the two legs 106a, 106b to the sample carrier 150, in order to clamp the sample carrier 150 between the two legs, when the sample carrier is received in the reception area 102. This is illustrated in an embodiment in Fig. 1c. By means of example, four force components Fa, Fb, Fc and Fd are illustrated by respective arrows. These force components, together, form the clamping force that is exerted by the sample holder 100 or its two legs, respectively, onto the sample carrier 150 or its outer rim, respectively. The outer rim 156 is shown in Fig. 1b.

In an embodiment, the sample holder 100 is configured to exert the clamping force to the sample carrier such that the clamping force is equally distributed to the two legs. This means that the force components Fa and Fb in combination (in vector and/or scalar addition) are equal to the force components Fc and Fc in combination (in vector and/or scalar addition) in terms of magnitude but have the opposite orientation. This can be achieved by forming the sample holder 100 such that the two legs 106a and 106b are laterally reversed to each other. The further distribution of the clamping force into the four components shown in Fig. 1c will be explained in more detail later.

In an embodiment, the sample holder 100 is formed such that a first minimum distance d1 between the free ends 110a, 110b of the two legs 106a, 106b, when the sample carrier is not received in the reception area 102 and when no external force is exerted to the sample holder (see Fig. 1a), is less than a second minimum distance d2 between the free ends 110a, 110b of the two legs 106a, 106b, when the sample carrier 150 is received in the reception area 102 (see Fig. 1c). This can be achieved in that a diameter d3 of the reception area 102 (which can be of, in general, round or circular shape for the circular shaped sample carrier 150, see Fig. 1a) is less than the (outer) diameter d4 of the sample carrier 150 (measured at the outer rim 156, see Fig. 1b).

This requires the two legs 106a and 106b - in particular at their respective free ends 110a, 110b - to be pulled slightly apart from each other, by means of an external force, such that the sample carrier 150 can be placed in the reception area 102. After the sample carrier 150 has been placed therein and after removal of such external force, the sample holder 100 provides the clamping force to the sample carrier 150 via and by the two legs 106a, 106b due to pre-tension and the special shape of the sample holder 100.

In an embodiment, the sample holder 100 comprises several distinct clamping surfaces 108a, 108b, 108c, 108d arranged to contact the sample carrier 150 or the outer rim 156, when the sample carrier 150 is received in the reception area 102. Each of the two legs 106a, 106b comprises at least part of each of at least two of the multiple clamping surfaces 108a, 108b, 108c, 108d. In the example shown in Fig. 1a, leg 106a comprises the clamping surfaces 108a and 108b, and leg 106b comprises the clamping surfaces 108c and 108d. Within the leg 106a, the clamping surfaces 108a and 108b are separated from each other by means of a recess 116a such that the surfaces 108a and 108b are distinct. Correspondingly, within the leg 106b, the clamping surfaces 108c and 108d are separated from each other by means of a recess 116b, such that the surfaces 108c and 108d are distinct.

The sample holder 100 is configured to exert the clamping force (with components Fa, Fb, Fc, Fd) via the several distinct clamping surfaces 108a, 108b, 108c, 108d. In particular, each of the several distinct clamping surfaces 108a, 108b, 108c, 108d corresponds to and exerts one of the components Fa, Fb, Fc, Fd. These distinct clamping surfaces allow to distribute the entire clamping force more evenly around the circumference or the outer rim 156 of the sample carrier 150. It is noted that even more than four clamping surfaces can be provided, for example, three or four per leg.

This can be achieved by providing the sample holder 100 with more recesses like recesses 116a, 116b.

In an embodiment, the clamping surfaces 108a, 108b, 108c, 108d are arranged such that they form part of a barrel or a cone surface, when the sample carrier is received in the reception area 102. This is of particular advantage for round shaped sample carriers like the one shown in Fig. 1b because then the clamping force can even better be distributed evenly around the circumference. It is noted that in such case the clamping surfaces 108a, 108b, 108c, 108d do not form part of barrel or a cone surface, when the sample carrier is not received in the reception area 102. This is due to the required pre-tension and has to be considered when manufacturing the sample holder.

If the clamping surfaces form part of a barrel surface, the entire clamping force and also the individual components are (at least essentially) oriented in the x-y-plane. If the clamping surfaces form part of a cone surface, the entire clamping force and also the individual components also have a component in z-direction. This allows, for example, providing a component of the clamping force oriented downwards, i.e., in negative z-direction (with the z axis of Fig. 1a) which results in pressing the sample carrier 150 downwards.

In an embodiment, the sample holder 100 further comprises several distinct support surfaces 112a, 112b, 112d configured to support the sample carrier 150 when the sample carrier is received in the reception area (102). At least part of each of at least two of the multiple support surfaces is arranged at each one of the two legs 106a, 106b and adjacent to a respective one of the multiple clamping surfaces 108a, 108b, 108c, 108d. In the example shown in Fig. 1b, one of the support surfaces is arranged adjacent to a respective one of the clamping surfaces (note that the support surface adjacent to clamping surface 108c is not visible in Fig. 1a). These support surfaces are, in particular, arranged and oriented such that they support the sample carrier 15 in a direction perpendicular to the top surface 104, as is shown in Fig. 1a. In other words, the support surface is parallel to the x-y-plane.

In this way, the specific position of the sample carrier 150, when received in the reception area 102 and support by (i.e., resting on) the support surfaces, with respect to height (i.e., in z-direction) can be chosen as required by choosing the position of the support surfaces accordingly (see also later Figs. 2 and 3). It is noted that the number of (distinct) support surfaces does not necessarily require to be identical to the number of clamping surfaces. Also, less support surfaces can be sufficient to support the sample carrier 150. Also, the size of the support surface can be different, for example, smaller that shown in Fig. 1a.

In an embodiment, the sample holder 100 comprises channels 114a, 114b, 114c, 114d, wherein each of the more channels connects a surface of a side of the sample holder 100 with a surface of a different side of the sample holder 100. In the embodiment shown in Figs. 1a and 1c, each of the channels 114a, 114b, 114c, 114d connects the top surface 104a with the bottom surface 104b. The channels can be positioned at respective corners of the sample holder 100. Further, these channels can be, for example, made as through holes or bores in the sample holder. Such channels allow cooling fluid flowing through them; this results in more efficient and faster cooling (or freezing), in particular, in high pressure freezing.

In an embodiment, the sample holder 100 comprises two or more operating recesses, which are all located at the same first side of the sample holder 100, for example, on the top surface 104. In the embodiment shown in Fig. 1, the sample holder 100 comprises four operating recesses, and, in particular, the operating recesses are formed by the channels 114a, 114b, 114c, 114d. In this way, the channels provide dual use for cooling and for handling the sample holder by means of a handing tool as will be described in more detail later. It is noted that in the embodiment shown in Fig. 1, operating recesses are also provided at the bottom side 104b as the channels, which form the operating recesses, are through holes.

Further, a distance d5a of the two operating recesses 114b and 114d is indicated. Such distance d5a can be measured between the center axes of the operating recesses, for example. Such distance d5a can be measured between the center axes of the operating recesses, for example. Further, a distance d5b of the two operating recesses 114a and 114c is indicated. Such distance d5b can be measured between the center axes of the operating recesses, for example.

Further, this distance d5b can be measured when no sample carrier is received in the sample holder 100. Similar like distance d1 between the two free ends 110a, 110b, distance d5b will increase to distance d5c, when a sample carrier is received in the sample holder 100 (see Fig. 1c). It is noted that distance d5a will not or not essentially change, when the sample carrier is placed in the sample holder 100. For example, the sample holder 100 can be configured such that distance 5c is equal to distance 5a.

To sum up, in the embodiment shown in Figs. 1a and 1c, the sample holder 100 has a slight recess 102 with a slightly smaller diameter (d3) than the sample carrier 150 (e.g., an autogrid, d4). Sample carriers like autogrids can be clamped into the sample holder 100 at the beginning of the cryo workflow. The particular square shape of the square grid shown in Figs. 1a and 1c is a possible and preferred implementation and allows a user to easily recognize a current orientation of the sample holder. The sample carrier can be clipped directly into the sample holder. The sample carrier is then held by the spring effect, which results from the lateral opening and the smaller diameter of the recess 102 ('spring clip holding principle'). This holding principle is a particular advantageous feature of the sample holder and can easily be transferred to differently shaped holders, i.e. other holders with a different shape (other than the square or cuboid shape shown in Figs. 1a, 1c) are also feasible with the same spring clip holding principle.

With such sample holder ("square grid"), direct contact between tweezers (or other handling tools) and the sample carrier is no longer necessary when manipulating the sample carrier or its grid. This makes the transfer much safer and faster. Minimizing transfer time also minimizes ice contamination. The relatively large material volume of the sample holder also ensures that the sample remains sufficiently cold and thus vitrified for a longer period of time without active cooling than a sample on a baregrid or sample holder without the sample holder. Thanks to the preferable non-rotationally symmetrical shape with corners and the one-sided opening, a constant orientation is guaranteed throughout the cryo workflow. This design allows the sample holder to be stacked and stored safely, space-savingly and easily removable under cryo conditions.

This also makes it easier to reuse the samples (or sample carriers) at a later point in time with the exact knowledge of the positions of previous measurements (as is also necessary for single particle analyses, for example). In addition, after modification of the corresponding microscope holder, the sample holders are compatible with already established technology (cryo correlative light and electron microscopy cryoCLEM, focused ion beam FIB, cryo-liftout, for example).

Another area of application are so-called high-pressure freezers. This technique allows biological samples to be frozen by supplying liquid nitrogen under very high pressure. So far, the cold samples have had to be placed on the grids after high-pressure freezing and possibly also thinned out mechanically. By modifying the existing holders in high-pressure freezers, it is possible with the sample holders as described herein to freeze samples directly on the grids. The optional channels can be introduced into the sample holder in order to direct the gases flowing during the high-pressure freezing process. With the simple transfer of the sample holder from the high-pressure freezer, a faster and safer workflow is achieved.

Fig. 2 schematically illustrates the arrangement of Fig. 1c, i.e., the sample holder 100 and the sample carrier 150, in a side view. For ease of reference, a Cartesian coordinate system with axes x, y and z is shown, which is in line with the one of Fig. 1a.

In this view, the top surface 104a and the opposite bottom surface 104b are shown. In addition, the sample carrier 150 protrudes from the top surface 104a of the sample holder 100 by a distance d6. This can be achieved by specifically arranging the support surfaces like 112a, 112b, 112d in z-direction shown in Fig. 1a accordingly. The distance d5 can, for example be 0.1 mm or more. This arrangement allows to bring light microscopy objectives, for example, very close to the samples with a very small working distance.

Fig. 3 schematically illustrates multiple ones of the arrangements of Fig. 2 stacked and in cross section. For ease of reference, a Cartesian coordinate system with axes x, y and z is shown, which is in line with the ones of Figs. 1a and 2. In particular, three sample holder 100a, 100b and 100c with corresponding sample carriers 150a, 150b and 150c are shown. Each of these sample holders 100a, 100b and 100c can correspond to the sample holder 100 shown in Figs. 1a, 1c and 2, and each of these sample carriers 150a, 150b and 150c can correspond to the sample carrier 150 shown in Figs. 1b, 1c and 2.

For sample holder 100a, the top surface 104a and, by means of example, the support surface 112d are shown. A distance between these two surfaces, in z-direction, is indicated with d8. In addition, a thickness (or height) of the sample carrier 150, in z-direction, is indicated with d7. It can be seen that in this embodiment, the distance (thickness) d7 is less than thickness d8. In particular, the sum of distance d6 (see Fig. 2) and d8 is equal to height or thickness d7. This shows that by arranging the support surface 112d (and also the other support surfaces) at a specific height in z-direction results in that the sample carrier 150 protrudes from the top surface 104a, when the sample carrier 150 is received in the reception area, clamped between the two legs and supported by the several distinct the support surfaces, as shown in Fig. 2. For example, the distance d6 can be chosen to be less than 0.4 mm or less than 0.35 mm. A typical value for thickness d7, in turn, is 0.4 mm. In this way, the sample carrier 150 will protrude from the top surface 104a, as shown in Fig. 2.

In an embodiment, the sample holder comprises a clearance area 318, which is indicated, by means of example, for sample holders 100a and 100c in Fig. 3. The clearance area 318 is formed at least partly as a recess in the bottom surface of the sample holder 100a. The clearance area 318 is configured to, when the sample carrier 150a is received in the reception area 102 and clamped between the two legs (i.e., when the distance between the free ends of the two legs is d2, see Fig. 1c), receive at least a part of another sample carrier of the same type (and preferably the same size and shape), without clamping the other sample carrier, when the other sample carrier is received in the reception area and clamped between the two legs of another sample holder of the same type. In Fig. 3, such other sample carrier corresponds to sample carrier 150, which is clamped between the two legs of sample holder 100b.

This allows stacking sample holders above each other, with sample carriers clamped in each of these sample holders, like shown in Fig. 3. In order to assure that the sample carrier clamped in the reception area in the other sample holder is not clamped in the clearance area of the stacked sample holder, a diameter of the clearance area, like diameter d9 shown in Fig. 3, can be chosen slightly larger than diameter d3 of the reception area. It is noted that the clearance area 318 can, for example, be formed similar to the reception area, however, at the bottom surface instead of the top surface. Just like for the reception area, it should be noted that the diameter of the clearance area is larger when a sample carrier is clamped in the sample holder than when not.

A height (or depth) of the clearance area 318, in z-direction, is indicated with distance d10 in Fig. 3. In order to allow stacking of sample holders, distance d10 should be larger than distance d6 (see Fig. 2) such that the sample carrier of the lower sample holder (for example sample carrier 150b in Fig. 3) does not touch the inner surface of the clearance area of the upper sample holder (for example sample holder 100a in Fig. 3). Note that distance d10 can also be chosen to have the same value as distance d8, for example.

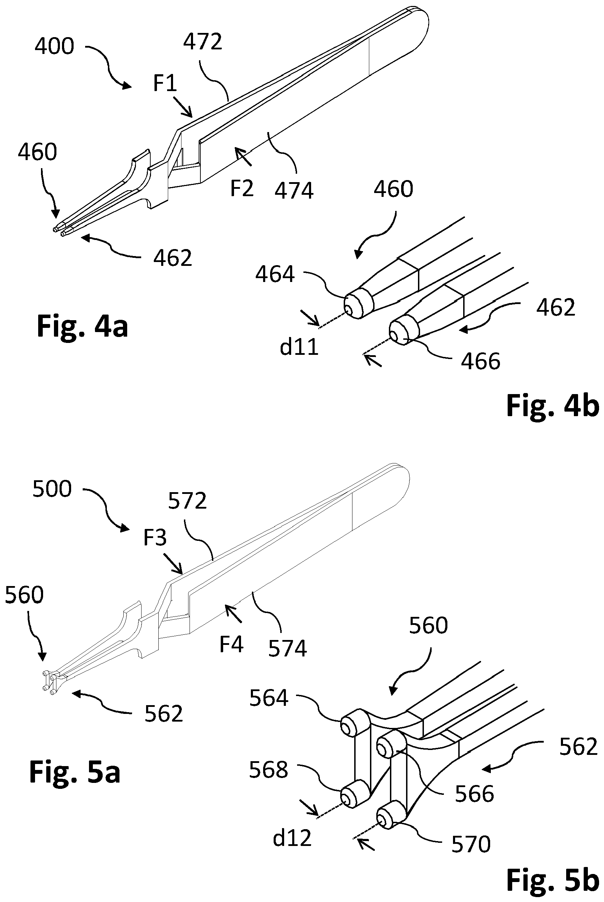

Fig. 4a schematically illustrates a handling tool 400 according to an embodiment of the invention. Fig. 4b schematically illustrates an enlarged view of a front part of the handling tool 400 of Fig. 4a. Figs. 4a and 4b will be described in common in the following.

The handling tool 400 is for use with a sample holder like the sample holder 100 shown in Figs. 1a and 1c, having operating recesses like 114a, 114b, 114c, 114d. The handling tool 400 comprises two ends 460 and 462, fitting into the two or at least two of the more operating recesses of the sample holder. In an embodiment, each of the two ends 460, 462 is configured as a gripping pin 464 and 466, respectively, configured to fit into a respective one of the operating recesses. Such gripping pins can have a cylindrical shape and a diameter slightly less than a diameter of an operating recess. This allows fitting a gripping pin into a corresponding operating recess.

The handling tool 400 is configured such that in absence of an external force to the handling tool 400, the two ends 460, 462 are spaced apart from each other by a distance, indicated with d11 in Fig. 4b. This distance d11 can be measured for example, between center axes of the gripping pins 464, 466. This distance d11 is less than a distance of two respective operating recesses, for example distance d5a and/or distance 5b shown in Fig. 1a. Further, the handling tool 400 is configured as inverse tweezers such that a squeezing force like F1, F2 in Fig. 4a applied to handling areas 472, 474 of the handling tool 400 pushes the two ends 460, 462 apart from each other.

In this way, when the handling tool 400 has to be squeezed in order to pushes the two ends 460, 462 apart from each other, such that the ends or gripping pins can be inserted into the respective operating recesses. The handling operating will be described in more detail later.

Fig. 5a schematically illustrates a handling tool 500 according to another embodiment of the invention. Fig. 5b schematically illustrates an enlarged view of a front part of the handling tool 500 of Fig. 5a. Figs. 5a and 5b will be described in common in the following.

The handling tool 500 is for use with a sample holder like the sample holder 100 shown in Figs. 1a and 1c, having operating recesses like 114a, 114b, 114c, 114d. The handling tool 500 comprises two ends 560 and 562, fitting into the two or at least two of the more operating recesses of the sample holder. In an embodiment, each of the two ends 560, 562 comprises two gripping pins 564, 568 and 566, 570, respectively, each gripping pin configured to fit into a respective one of the operating recesses. Such gripping pins can have a cylindrical shape and a diameter slightly less than a diameter of an operating recess. This allows fitting a gripping pin into a corresponding operating recess.

The handling tool 500 is configured such that in absence of an external force to the handling tool 500, the two ends 560, 562 are spaced apart from each other by a distance, indicated with d12 in Fig. 5b. This distance d12 can be measured for example, between center axes of two opposing gripping pins 568, 570 (one of each end); typically, such distance would be the same for the other two gripping pins. This distance d12 is less than a distance of two respective opposing operating recesses, for example distance d5a shown in Fig. 1a; distance d5a is, for example, equal to distance d5c shown in Fig. 1c. Further, the handling tool 500 is configured as inverse tweezers such that a squeezing force like F2, F3 in Fig. 5a applied to handling areas 572, 574 of the handling tool 500 pushes the two ends 560, 562 apart from each other.

In this way, when the handling tool 500 has to be squeezed in order to pushes the two ends 560, 562 apart from each other, such that the ends or gripping pins can be inserted into the respective operating recesses. The handling operating will be described in more detail later.

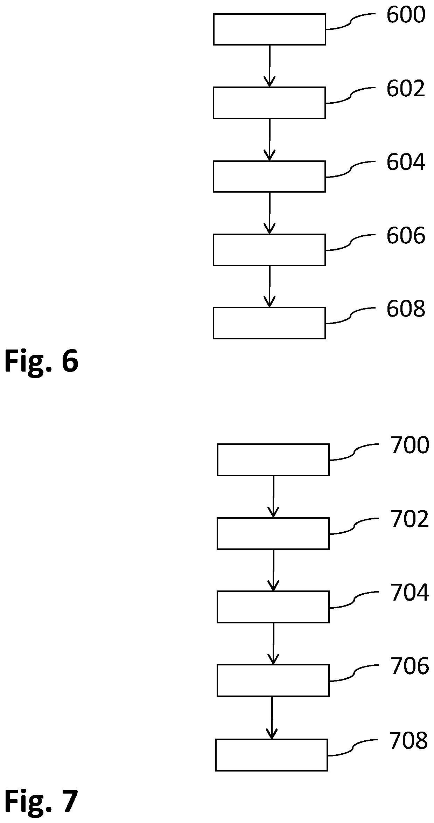

Fig. 6 schematically illustrates a method according to an embodiment of the invention in a flow diagram. The method relates to placing a sample carrier like sample carrier 150 into a sample holder like sample holder 100, using a handling tool like the handling tool 400 or 500 described above. In a step 600, a squeezing force like force F1, F2 in Fig. 4a or force F3, F4 in Fig. 5a is applied to the handling areas of the handling tool as described with respect to Figs. 4a and 5a. This squeezing force pushes the two ends apart from each other.

In step 602, the two ends of the handling tool are placed into the respective operating recesses of the sample holder, when the squeezing force is (still) applied. Depending on the handling tool used, either the two gripping pins of handling tool 400 or the four gripping pins of handling tool 500 are to be placed in respective operating recesses. Care should be taken that the squeezing force is chosen such that the two ends area spaced apart such that the gripping pins fit easily into the operating recesses. In particular, in case of handling tool 500, an easy way of fitting the gripping pins to the operating recesses is to fit two gripping pins into operating recesses 114a and 114c first, applying a little more squeezing force and then to fit the other two gripping pins into operating recesses 114b and 114d.

In step 604, the sample carrier is then placed into in the reception area, while the squeezing force still or again is applied. The squeezing force should be chosen such that the two legs of the sample holder or their free ends are spaced apart sufficiently. After having placed the sample carrier in the sample holder, in step 606, the squeezing force is removed from the handling tool partly. In this way, the external force to the sample holder can be released, however, some squeezing force is still required for the next step. Then, in step 608, the two ends of the handling tool are removed from the respective operating recesses of the sample holder.

This results in the sample carrier being clamped in the sample holder. Further handling of the sample holder (with the sample carrier clamped) can include placing the ends of the handling tool in the respective operating recesses, while taking care that the two legs of the sample holder or their free ends are not further spaced apart. This is supported by the inverse-tweezer style of the handling tool.

Fig. 7 schematically illustrates a method according to a further embodiment of the invention in a flow diagram. The method relates to removing a sample carrier like sample carrier 150 from a sample holder like sample holder 100, using a handling tool like the handling tool 400 or 500 described above. In a step 700, a squeezing force like force F1, F2 in Fig. 4a or force F3, F4 in Fig. 5a is applied to the handling areas of the handling tool as described with respect to Figs. 4a and 5a. This squeezing force pushes the two ends apart from each other.

In step 702, the two ends of the handling tool are placed into the respective operating recesses of the sample holder, when the squeezing force is (still) applied. Depending on the handling tool used, either the two gripping pins of handling tool 400 or the four gripping pins of handling tool 500 are to be placed in respective operating recesses. Care should be taken that the squeezing force is chosen such that the two ends area spaced apart such that the gripping pins fit easily into the operating recesses.

In step 704, the sample carrier is removed from the reception area, while the squeezing force still or again is applied. The squeezing force should be chosen such that the two legs of the sample holder or their free ends are spaced apart sufficiently. After having removed the sample carrier from the sample holder, in step 706, the squeezing force is removed from the handling tool partly. In this way, the external force to the sample holder can be released, however, some squeezing force is still required for the next step. Then, in step 678, the two ends of the handling tool are removed from the respective operating recesses of the sample holder.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

### List of Reference Signs

- 100, 100a, 100b, 100c: sample holder
- 102: reception area
- 104a: top surface
- 104b: bottom surface
- 106a, 106b: legs
- 108a, 108b, 108c, 108d: clamping surfaces
- 110a, 110b: free ends
- 112a, 112b, 112d: support surfaces
- 114a, 114b, 114c, 114d: operating recesses, channels
- 116a, 116b: recesses
- 150, 150a, 150b, 150c: sample carrier
- 152: grid
- 154: frame
- 156: outer rim
- 158: ring

- 318: clearance area

- 400, 500: handling tool
- 460, 462, 560, 562: ends
- 464, 466, 564, 566, 568, 570: gripping pins
- 472, 474, 572, 574: handling areas

- 600-608, 700-708: methods steps

- d1, d2, d5-d6, d8, d10-d12: distances
- d3, d4, d9: diameters
- d7: thickness of sample carrier
- Fa, Fb, Fc, Fd: clamping force
- F1, F2, F3, F4: squeezing force
- x, y, z: directions

## Claims

1. A sample holder (100, 100a, 100b, 100c) for holding a sample carrier (150, 150a, 150b, 150c), wherein the sample holder comprises a reception area (102) configured to receive the sample carrier (150, 150a, 150b, 150c),
wherein the sample holder comprises two legs (106a, 106b), wherein the two legs (106a, 106b) are connected to each other and wherein each leg has a free end (110a, 110b), and
wherein the sample holder is configured to exert a clamping force (Fa, Fb, Fc, Fd) via the two legs (106a, 106b) to the sample carrier, in order to clamp the sample carrier (150, 150a, 150b, 150c) between the two legs, when the sample carrier is received in the reception area (102).

2. The sample holder (100, 100a, 100b, 100c) of claim 1, wherein a first minimum distance (d1) between the free ends (110a, 110b) of the two legs (106a, 106b), when the sample carrier is not received in the reception area (102) and when no external force is exerted to the sample holder, is less than a second minimum distance (d2) between the free ends (110a, 110b) of the two legs (106a, 106b), when the sample carrier (150, 150a, 150b, 150c) is received in the reception area (102).

3. The sample holder (100, 100a, 100b, 100c) of claim 1 or 2, configured to exert the clamping force (Fa, Fb, Fc, Fd) to the sample carrier such that the clamping force (Fa, Fb, Fc, Fd) is equally distributed to the two legs (106a, 106b).

4. The sample holder (100, 100a, 100b, 100c) of any one of the preceding claims, comprising several distinct clamping surfaces (108a, 108b, 108c, 108d) arranged to contact the sample carrier (150, 150a, 150b, 150c) or an outer rim (156) of the sample carrier (150, 150a, 150b, 150c), when the sample carrier (150, 150a, 150b, 150c) is received in the reception area (102),
wherein each of the two legs (106a, 106b) comprises at least part of each of at least two of the multiple clamping surfaces (108a, 108b, 108c, 108d), and
wherein the sample holder (100, 100a, 100b, 100c) is configured to exert the clamping force (Fa, Fb, Fc, Fd) via the several distinct clamping surfaces (108a, 108b, 108c, 108d).

5. The sample holder (100, 100a, 100b, 100c) of claim 4, wherein the one or more clamping surfaces (108a, 108b, 108c, 108d) are arranged such that they form part of a barrel or a cone surface, when the sample carrier is received in the reception area (102).

6. The sample holder (100, 100a, 100b, 100c) of claim 4 or 5, further comprising several distinct support surfaces (112a, 112b, 112d) configured to support the sample carrier (150, 150a, 150b, 150c), when the sample carrier is received in the reception area (102),
wherein at least part of each of at least two of the multiple support surfaces is arranged at each one of the two legs (106a, 106b) and adjacent to a respective one of the multiple clamping surfaces (108a, 108b, 108c, 108d).

7. The sample holder (100, 100a, 100b, 100c) of any one of the preceding claims, wherein the reception area (102) is formed at least partly as a recess in a top surface (104a) of the sample holder (100),
wherein the sample holder (100, 100a, 100b, 100c) is U-shaped, seen in a plane parallel to the top surface (104), and
wherein at least a part of each of the two legs (106a, 106b) forms at least a part of the reception area (102).

8. The sample holder (100, 100a, 100b, 100c) of claim 7, comprising a clearance area, wherein the clearance area is formed at least partly as a recess in a bottom surface of the sample holder (100, 100a, 100b, 100c), wherein the bottom surface is opposite the top surface (104a),
wherein the clearance area is configured to, when the sample carrier (150, 150a, 150b, 150c) is received in the reception area (102) and clamped between the two legs (106a, 106b), receive at least a part of another sample carrier of the same type without clamping the other sample carrier, when the other sample carrier is received in the reception area (102) and clamped between the two legs (106a, 106b) of another sample holder of the same type.

9. The sample holder (100, 100a, 100b, 100c) of any one of the preceding claims, comprising one or more channels (114a, 114b, 114c, 114d), wherein the one channel or each of the more channels connects a surface of a side of the sample holder (100, 100a, 100b, 100c) with a surface of a different side of the sample holder (100, 100a, 100b, 100c).

10. The sample holder (100, 100a, 100b, 100c) of any one of the preceding claims, comprising two or more operating recesses (114a, 114b, 114c, 114d), wherein the two or more operating recesses are located on the same first side of the sample holder (100, 100a, 100b, 100c).

11. The sample holder (100, 100a, 100b, 100c) of claims 9 and 10, wherein at least one of the operating recesses (114a, 114b, 114c, 114d) is formed by the one or at least one of the more channels (114a, 114b, 114c, 114d).

12. The sample holder (100, 100a, 100b, 100c) of any one of the preceding claims, referring back at least to claims 6 and 7, wherein a distance (d8) between the top surface (104a) and at least one of the several distinct support surfaces (112a, 112b, 112d), seen in a direction (z) orthogonal to the top surface (104a), is less than 0.4 mm or less than 0.35 mm.

13. Arrangement comprising the sample holder (100, 100a, 100b, 100c) of any one of the preceding claims, referring back at least to claims 6 and 7, and a sample carrier (150), wherein the sample holder (100, 100a, 100b, 100c) is configured such that, when the sample carrier (150) is received in the reception area (102), clamped between the two legs (106a, 106b) and supported by the several distinct the support surfaces (112a, 112b, 112d), the sample carrier protrudes from the top surface (104a).

14. A handling tool (400, 500) for use with the sample holder (100, 100a, 100b, 100c) of any one of claims 1 to 12, referring back at least to claims 10 and 11, wherein the handling tool (400, 500) comprises two ends (460, 462; 560, 562) fitting into the two or at least two of the more operating recesses of the sample holder (100, 100a, 100b, 100c),
wherein the handling tool (400, 500) is configured such that in absence of an external force to the operating tool the two ends are spaced apart from each other by a distance (d11, d12) less than a distance (d5a, d5b, d5c) of the two respective operating recesses, and
wherein the handling tool (400, 500) is configured as inverse tweezers such that a squeezing force (F1, F2; F3, F4) applied to handling areas (472, 474; 572, 574) of the operating tool pushes the two ends apart.

15. A method of placing a sample carrier (150, 150a, 150b, 150c) into a sample holder (100, 100a, 100b, 100c), using a handling tool (400, 500), comprising:
applying (600) a squeezing force (F1, F2; F3, F4) to handling areas (472, 474; 572, 574) of the handling tool;
placing (602) two ends (460, 462; 560, 562) of the handling tool into respective operating recesses of the sample holder, when the squeezing force is applied;
placing (604) the sample carrier in a reception area (102) of the sample holder (100, 100a, 100b, 100c), while the squeezing force still or again is applied;
removing (606) the squeezing force (F1, F2; F3, F4) from the handling tool partly; and
removing (608) the two ends of the handling tool from the respective operating recesses of the sample holder.

16. A method of removing a sample carrier (150, 150a, 150b, 150c) from a sample holder (100, 100a, 100b, 100c), using a handling tool, comprising:
applying (700) a squeezing force (F1, F2; F3, F4) to handling areas (472, 474; 572, 574) of the handling tool;
placing (702) two ends of the handling tool into respective operating recesses of the sample holder, while the squeezing force is being applied;
removing (704) the sample carrier from a reception area (102) of the sample holder (100, 100a, 100b, 100c), while the squeezing force still or again is applied;
removing (706) the squeezing force (F1, F2; F3, F4) from the handling tool partly; and
removing (708) the two ends of the handling tool from the respective operating recesses of the sample holder.
